(19) Europäisches Patentamt
European Patent Office
Office européen des brevets

(11) **EP 3 559 751 B1**

(12) **EUROPÄISCHE PATENTSCHRIFT**

(45) Veröffentlichungstag und Bekanntmachung des Hinweises auf die Patenterteilung:
**31.08.2022  Patentblatt 2022/35**

(21) Anmeldenummer: **17816796.1**

(22) Anmeldetag: **14.12.2017**

(51) Internationale Patentklassifikation (IPC):
**G03F 7/20** (2006.01)        **G02B 6/10** (2006.01)
**F21V 8/00** (2006.01)

(52) Gemeinsame Patentklassifikation (CPC):
**G03F 7/70075; G02B 6/0096; G03F 7/70033;**
G02B 6/102

(86) Internationale Anmeldenummer:
**PCT/EP2017/082819**

(87) Internationale Veröffentlichungsnummer:
**WO 2018/114591 (28.06.2018 Gazette 2018/26)**

(54) **HOHLWELLENLEITER ZUR FÜHRUNG VON EUV-LICHT MIT EINER NUTZWELLENLÄNGE**

HOLLOW WAVEGUIDE FOR GUIDING EUV LIGHT WITH A USEFUL WAVELENGTH

GUIDE D'ONDE CREUX DESTINÉ À L'ACHEMINEMENT DE LUMIÈRE EUV D'UNE LONGUEUR D'ONDE UTILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.12.2016  DE 102016225563**

(43) Veröffentlichungstag der Anmeldung:
**30.10.2019  Patentblatt 2019/44**

(73) Patentinhaber: **Carl Zeiss SMT GmbH**
**73447 Oberkochen (DE)**

(72) Erfinder: **DEGÜNTHER, Markus**
**73432 Aalen (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
**EP-A2- 1 058 156      DE-A1-102013 204 443**
**US-A- 5 109 465      US-A1- 2011 058 388**

**Beschreibung**

Die vorliegende Patentanmeldung nimmt die Priorität der deutschen Patentanmeldung DE 10 2016 225 563.0 in Anspruch.

Die Erfindung betrifft einen Hohlwellenleiter zur Führung von EUV-Licht mit einer Nutzwellenlänge. Ferner betrifft die Erfindung eine Beleuchtungsoptik mit einem derartigen Hohlwellenleiter, ein optisches System mit einer derartigen Beleuchtungsoptik und einer EUV-Lichtquelle, eine Projektionsbelichtungsanlage mit einem derartigen Beleuchtungssystem und einer Projektionsoptik, ein Verfahren zur Herstellung eines mikro- beziehungsweise nanostrukturierten Bauteils unter Einsatz einer derartigen Projektionsbelichtungsanlage .

Ein Hohlwellenleiter der eingangsgenannten Art ist bekannt aus der WO 2014/139881 A1. Aus der WO 2013/174644 A1 ist ein Facettenspiegel mit Streustrukturen bekannt. Streustrukturen als Bestandteil einer optischen Baugruppe zur simultanen Lichtleitwerterhöhung sind zudem bekannt aus der WO 2014/139815 A1 beziehungsweise der DE 10 2013 204 443 A1. Hohlwellenleiter sind zudem bekannt aus der US 6,552,846 B1 und der WO 2016/046088 A1. Die US 2011/0058388 A1 beschreibt einen Wellenleiter mit einer Rippenstruktur. Die US 5,109,465 beschreibt eine Homogenisiereinrichtung für ein Lichtbündel. Die EP 1 058 156 A2 offenbart einen Wellenleiter zum Einsatz in einer Projektionsbelichtungsanlage.

Es ist eine Aufgabe der vorliegenden Erfindung, einen Hohlwellenleiter der eingangsgenannten Art derart weiterzubilden, dass eine homogenisierende Wirkung von diesem auf das geführte EUV-Licht verbessert ist.

Diese Aufgabe ist erfindungsgemäß gelöst durch einen Hohlwellenleiter mit dem im Anspruch 1 angegebenen Merkmal.

Erfindungsgemäß wurde erkannt, dass die Ausführung eines Hohlwellenleiters mit einer Beugungsstrukturen tragenden Innenwand überraschenderweise nicht dazu führt, dass der Hohlwellenleiter aufgrund mangelndem EUV-Durchsatz unbrauchbar wird. Stattdessen hat sich ergeben, dass die beugende Wirkung der Innenwand des Hohlwellenleiters mehrere Funktionen erfüllt, die sich zur Beleuchtungslicht-Homogenisierung vorteilhaft ergänzen. Zum einen führt die beugende Wirkung zu einer erwünschten Lichtleitwerterhöhung am Ausgang des Hohlwellenleiters. Und zum anderen führt die beugende Wirkung dazu, dass sich am Austritt des Hohlwellenleiters viele verschiedene Einzelstrahlen des Beleuchtungslichts überlagern, die längs verschiedener und regelmäßig längs verschieden langer optischer Wege geführt sind. Dies sorgt einerseits zu einer guten Durchmischung und statistischen Überlagerung der Einzelstrahl-Beleuchtungslichtintensitäten, was in Fällen, in denen eine optische Weglängendifferenz zwischen sich in der Austrittsfläche überlagernden Einzelstrahlen größer ist als eine Kohärenzlänge der Lichtquelle, zu der Reduzierung eines Speckle-Kontrastes und andererseits zur Vermeidung von Speckle-Mustern führt. Das Speckle-Phänomen ist diskutiert in dem Fachbuch "Speckle Phenomena in Optics: Theory and Applications" von Joseph W. Goodman, Roberts & Company, 2007. Die Beugungsstrukturen stellen eine spezielle Form von Streustrukturen mit entsprechend an die Nutzwellenlänge zur Erzielung eines Beugungseffektes angepasster Strukturgröße dar.

Der Streuwinkelbereich des von der Innenwand gebeugten EUV-Lichts, also das Ausfallswinkelspektrum, dass von den Beugungsstrukturen erzeugt wird, kann zwischen 0 mrad und 30 mrad, insbesondere zwischen 0 mrad und 20 mrad oder zwischen 0 mrad und 10 mrad liegen. Ein Maximalwert dieses Winkelbereichs kann auch kleiner sein als 10 mrad, beispielsweise 8 mrad, 6 mrad oder 5 mrad. Ein Minimalwert dieses Winkelbereichs kann größer sein als 1 mrad, kann größer sein als 2 mrad, kann größer sein als 3 mrad, kann größer sein als 5 mrad, kann größer sein als 10 mrad oder kann auch noch größer sein.

Ein Einfallswinkel nach Anspruch 2 sorgt für einen hohen Durchsatz des EUV-Lichts beim Durchgang durch den Hohlwellenleiter. Der Einfallswinkel kann jeweils größer sein als 75°, kann größer sein als 78°, kann größer sein als 80°, kann größer sein als 82°, kann größer sein als 84°, kann größer sein als 85°, kann größer sein als 86°, kann größer sein als 87° und kann auch noch größer sein.

Ein Hohlwellenleiter mit einem Dimensionsverhältnis nach Anspruch 3 führt zwingend zu einem vorteilhaft großen Einfallswinkel des EUV-Lichts beim Durchgang durch den Hohlwellenleiter.

Eine Reflexionsbeschichtung nach Anspruch 4 erhöht den EUV-Durchsatz des Hohlwellenleiters. Die Reflexionsbeschichtung kann ein- oder mehrlagig ausgeführt sein. Die Reflexionsbeschichtung kann eine Mehrzahl von Bilagen aufweisen, die aus alternierenden Materialschichten ausgeführt sind.

Ein rechteckiger Innenquerschnitt des Hohlwellenleiters erleichtert dessen Herstellung. Der Innenquerschnitt kann quadratisch sein.

Eine Ausleuchtung der Austrittfläche mit einer Intensitätsverteilung nach Anspruch 6 führt zu einer besonders homogenen Durchmischung des EUV-Beleuchtungslicht am Austritt des Hohlwellenleiters.

Die Vorteile einer Beleuchtungsoptik nach Anspruch 7, eines optischen Systems nach Anspruch 8, eines Beleuchtungssystems nach Anspruch 9, einer Projektionsbelichtungsanlage nach Anspruch 12, eines Herstellungsverfahren nach Anspruch 13 entsprechen denen, die vorstehend unter Bezugnahme auf den erfindungsgemäßen Hohlwellenleiter diskutiert wurden.

Eine Kohärenzlänge k der EUV-Lichtquelle des Beleuchtungssystems nach Anspruch 10 kann größer sein als 1 $\mu$m, kann größer sein als 2 $\mu$m, kann größer sein als 5 $\mu$m, kann größer sein als 8 $\mu$m und kann im Bereich von 10 $\mu$m liegen. Die Kohärenzlänge k kann noch größer sein. Die Kohärenzlänge k ist der maximale optische Weglängenunterschied zweier Strahlen aus derselben Quelle, bei der bei Überlagerung noch ein Interferenzkontrast (Intensitätsverhältnis zwischen Interferenzminimum und Interferenzmaximum) von mindestens 50% vorliegt.

Relationen nach Anspruch 11 ergeben vorteilhafte Auslegungen des Hohlwellenleiters beziehungsweise einer Einfalls-Geometrie des EUV-Beleuchtungslicht in den Hohlwellenleiter beziehungsweise von Streu- beziehungsweise Beugungsstrukturen an einer Innenwand des Hohlwellenleiters.

Bei dem mikro- beziehungsweise nanostrukturierten Bauteil handelt es sich um ein Halbleiter-Bauteil, insbesondere um einen Mikrochip, beispielsweise um einen höchstintegrierten Speicherchip.

Ein Ausführungsbeispiel wird nachfolgend anhand der Zeichnungen näher erläutert. In dieser zeigen:

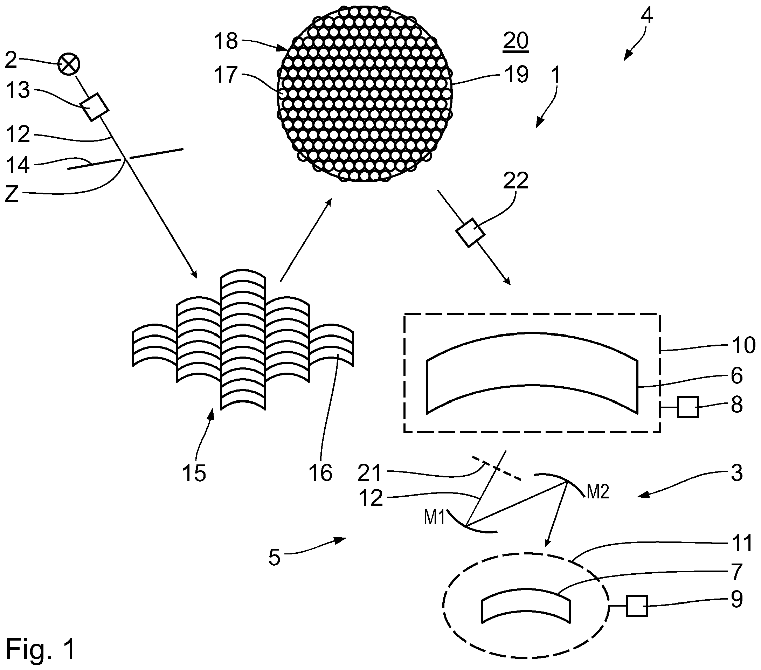

Fig. 1    schematisch Hauptkomponenten einer Projektionsbelichtungsanlage für die EUV-Projektionslithografie;

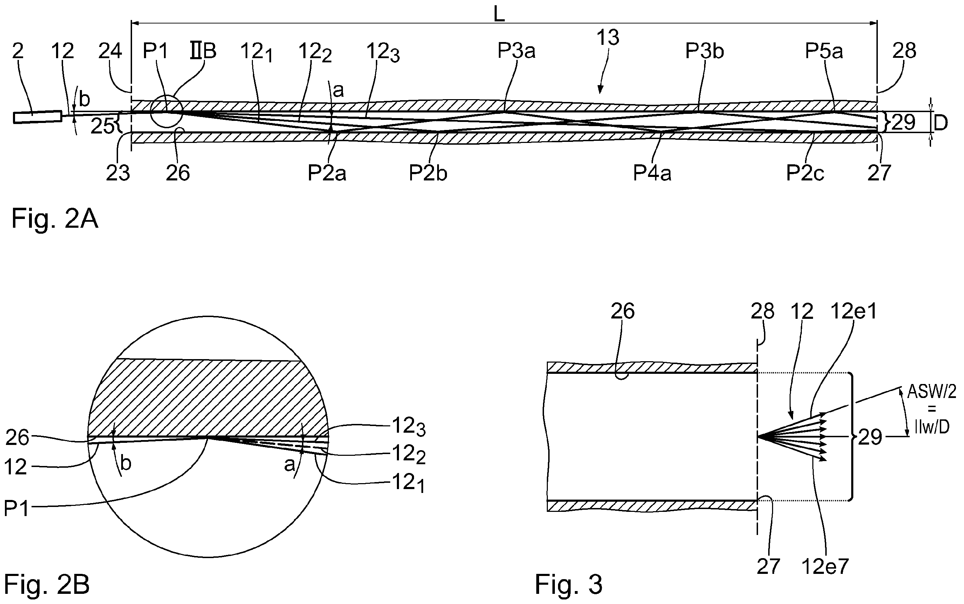

Fig. 2    schematisch eine EUV-Lichtquelle sowie einen EUV-Hohlwellenleiter zur Führung von EUV-Beleuchtungslicht, wobei ein Beleuchtungslicht-Strahlengang für einige Reflexionen des EUV-Beleuchtungslichts an einer Innenwand des Hohlwellenleiters schematisch dargestellt ist und wobei zusätzlich in einer Ausschnittsvergrößerung ein Streuwinkel eines einfallenden Beleuchtungslicht-Strahls bei der Reflexion an der Hohlwellenleiter-Innenwand verdeutlich ist;

Fig. 3    im Vergleich zur Fig. 2 vergrößert einen Abschnitt des Hohlwellenleiters im Bereich einer Austrittsfläche, wobei für einen ausgewählten Austrittspunkt in einer Ebene der Austrittsfläche verschiedene, diesen Austrittspunkt durchtretende Beleuchtungslichtstrahlen mit unterschiedlichen Strahlrichtungen dargestellt sind, wobei diese Beleuchtungslichtstrahlen innerhalb des Hohlwellenleiters in der Regel unterschiedliche optische Weglängen zurückgelegt haben.

Fig. 1 zeigt schematisch eine Beleuchtungsoptik 1, eine Lichtquelle 2 und eine abbildende Optik beziehungsweise Projektionsoptik 3 einer Projektionsbelichtungsanlage 4 der EUV-Mikrolithografie. Ein Beleuchtungssystem 5 der Projektionsbelichtungsanlage 4 hat neben der Beleuchtungsoptik 1, die zur Beleuchtung eines Objektfeldes 6 der Projektionsbelichtungsanlage dient, die Projektionsoptik 3 zur Abbildung des Objektfeldes 6, das in einer Objektebene liegt, in ein Bildfeld 7 in einer Bildebene. Neben dem Beleuchtungssystem 5 und der EUV-Lichtquelle 2 hat die Projektionsbelichtungsanlage 4 insbesondere noch eine Mehrzahl mechanischer Komponenten, Halter 8, 9 für ein in der Objektebene angeordnetes, in der Fig. 1 gestrichelt dargestelltes Retikel 10 und für einen in der Bildebene angeordneten, in der Fig. 1 gestrichelt dargestellten Wafer 11. Abgebildet wird eine Struktur auf dem Retikel 10 auf eine lichtempfindliche Schicht des im Bereich des Bildfeldes 7 in der Bildebene angeordneten Wafers 11.

Die abbildende Optik 3 ist als katoptrische Optik mit einer Mehrzahl von Spiegeln ausgeführt, von denen in der Fig. 1 schematisch zwei Spiegel M1, M2, dargestellt sind. Die abbildende Optik 3 hat in der Regel eine größere Anzahl von Spiegeln beispielsweise vier, sechs oder acht Spiegel.

Bei der Licht- beziehungsweise Strahlungsquelle 2 handelt es sich um eine EUV-(Extremes Ultraviolett) Lichtquelle mit einer emittierten Nutzstrahlung im Bereich zwischen 5 nm und 30 nm. Bei der Lichtquelle 2 handelt es sich um eine kohärente Lichtquelle. Ein für die EUV-Projektionsbelichtung genutztes Wellenlängenband beziehungsweise ein Ziel-Wellenlängenbereich der EUV-Strahlung 12 liegt beispielsweise bei 13,5 nm $\pm$ 1 nm, kann aber auch beispielsweise im Bereich zwischen 5 nm und 8 nm liegen. Die EUV-Strahlung 12 wird nachfolgend auch als Beleuchtungs- und Abbildungslicht oder als Nutz-Emission bezeichnet. Auch ein anderer Ziel-Wellenlängenbereich, beispielsweise zwischen 5 nm und 17 nm, ist möglich. Eine Bandbreite des genutzten EUV-Wellenlängenbandes kann größer sein als 0,1 nm und kann insbesondere zwischen 0,1 nm und 2 nm liegen. Eine typische Bandbreite der genutzten EUV-Strahlung 12 beträgt 1 % der Mittelwellenlänge.

Bei der Lichtquelle 2 handelt es sich um eine Synchrotonquelle oder um eine Quelle auf Basis eines freien Elektronenlasers (FEL). Die Lichtquelle 2 hat einen Lichtleitwert, der kleiner ist als $10^{-7} m^2$ oder 0,1 mm$^2$. Der Lichtleitwert 2 ist das kleinste Volumen des Phasenraums, welcher 90% der Lichtenergie enthält. Eine Wellenlängen-Bandbreite der Lichtquelle 2 kann sehr viel größer sein als die Bandbreite des genutzten EUV-Wellenlängenbandes und kann beispielsweise bei 0,1 $\mu$m liegen.

Der Lichtquelle 2 ist im Strahlengang der Nutz-Emission 12 nachgeordnet eine optische Baugruppe 13 zur simultanen Lichtleitwerterhöhung der Nutz-Emission 12 der Lichtquelle 2. Die optische Baugruppe 13 ist in der Fig. 1 lediglich schematisch angedeutet. Ausführungen der optischen Baugruppe 13 werden nachfolgend anhand der Fig. 2 und 3 noch erläutert. Der optischen Baugruppe 13 kann ein Umlenkspiegel für die Nutz-Emission 12 nachgeordnet sein.

Die erzeugte EUV-Strahlung 12 mit dem erhöhten Lichtleitwert propagiert durch eine Zwischenfokusebene 14, bevor sie auf einen Feldfacettenspiegel 15 mit Feldfacetten 16 trifft, die vom Beleuchtungslicht 12 beaufschlagt werden. Alternativ zur in Fig. 1 dargestellten Abfolge, bei der die Zwischenfokusebene 14 im Strahlengang der Nutz-Emission nach der optischen Baugruppe 13 angeordnet ist, kann die Zwischenfokusebene 14 auch im Strahlengang der Nutz-Emission vor der optischen Baugruppe 13 angeordnet sein. Vor der optischen Baugruppe 13 kann die EUV-Strahlung 12 langbrennweitig fokussiert sein. Anstelle eines reellen Fokus kann durch Strahlaufweiten auch ein imaginärer Fokus entstehen. Die Feldfacetten 16 sind bogenförmig, können aber auch rechteckig gestaltet sein. Auch eine andere Form der Feldfacetten 16 ist möglich.

In der Zwischenfokusebene 14 hat die EUV-Strahlung einen Zwischenfokus Z, das heißt, einen Ort kleinster transversaler Ausdehnung. Je nach Ausführung der Beleuchtungsoptik 1 kann auf die Bildung eines derartigen Zwischenfokus Z nach der optischen Baugruppe 13 auch verzichtet werden.

Die vom Feldfacettenspiegel 15 reflektierte EUV-Strahlung 12 ist aus einer Vielzahl von Ausleuchtungskanälen, also von Strahlungs-Teilbündeln, aufgebaut, wobei jedes Teilbündel von einer bestimmten Feldfacette 16 reflektiert wird. Jedes Teilbündel trifft wiederum auf eine dem Teilbündel über den Ausleuchtungskanal zugeordnete Pupillenfacette 17 eines Pupillenfacettenspiegels 18.

Die Pupillenfacetten 17 sind auf einer gemeinsamen Trägerplatte 19 des Pupillenfacettenspiegels 18 angeordnet. Der Pupillenfacettenspiegel ist in einer Beleuchtungs-Pupillenebene 20 angeordnet. Die Pupillenfacetten 17 sind rund ausgeführt. Alternativ ist auch eine hexagonale oder rechteckige Ausführung der Pupillenfacetten 17 möglich. Die Pupillenfacetten 17 sind dicht gepackt angeordnet. Mit dem Feldfacettenspiegel 15 werden am Ort der Pupillenfacetten 17 des Pupillenfacettenspiegels 18 sekundäre Lichtquellen erzeugt. Der Pupillenfacettenspiegel 18 ist in einer Ebene der Beleuchtungsoptik 1 angeordnet, die mit einer Pupillenebene 21 der Projektionsoptik 3 zusammenfällt oder zu dieser optisch konjugiert ist. Eine Intensitätsverteilung der EUV-Strahlung 12 auf dem Pupillenfacettenspiegel 17 ist daher direkt korreliert mit einer Beleuchtungswinkelverteilung einer Beleuchtung des Objektfeldes 6 in der Objektebene und einer Beleuchtung des Bildfeldes 7 in der Bildebene.

Mithilfe des Pupillenfacettenspiegels 18 und einer abbildenden optischen Baugruppe in Form einer schematisch angedeuteten Übertragungsoptik 22 werden die Feldfacetten 16 des Feldfacettenspiegels 15 in das Objektfeld 6 abgebildet. Auch Ausführungen der Projektionsbelichtungsanlage 4 sind möglich, bei denen die Beleuchtungs-Pupillenebene 20 mit der Projektionsoptik-Pupillenebene 21 zusammenfällt. In einem solchen Fall kann auf die Übertragungsoptik 22 auch verzichtet werden.

Die lichtleitwerterhöhende optische Baugruppe 13 kann alternativ zur vorstehend erläuterten Feldfacetten/Pupillenfacetten-Anordnung auch mit einem anderen Beleuchtungskonzept, insbesondere für die Projektionsbelichtung, kombiniert werden. Ein Beispiel für ein solches weiteres Beleuchtungskonzept ist ein spekularer Reflektor, der beispielsweise beschrieben ist in der US 2006/0132747 A1, der EP 1 614 008 B1 und der US 6,573,978.

Fig. 2 zeigt eine Ausführung der optischen Baugruppe 13 zur simultanen Lichtleitwerterhöhung der Nutz-Emission 12 der Lichtquelle 2. Die optische Baugruppe 13 führt zur Erhöhung des Lichtleitwertes um mindestens einen Faktor 10. Als simultane Lichtleitwerterhöhung wird dabei eine Lichtleitwerterhöhung bezeichnet, die die Nutz-Emission 12 selbst zu einem gegebenen Zeitpunkt tatsächlich aufweist. Eine sequentielle Lichtleitwerterhöhung, die beispielsweise über einen Scanspiegel erzeugt werden kann, über den die Nutz-Emission 12 abgelenkt wird, ist keine simultane Lichtleitwerterhöhung.

Die lichtleitwerterhöhende optische Baugruppe 13 ist ausgeführt als Hohlwellenleiter zur Führung des EUV-Beleuchtungslichts 12. Letzteres wird, ausgehend von der Lichtquelle 2 durch eine Eintrittsöffnung 23 des Hohlwellenleiters 13 in diesen eingestrahlt. Die Eintrittsöffnung 23 liegt in einer Eintrittsebene 24. Derjenige Abschnitt der Eintrittsebene 24, der mit der Eintrittsöffnung 23 zusammenfällt, wird auch als Eintrittsfläche 25 bezeichnet. Das die Eintrittsfläche 25 durchtretende Beleuchtungslicht 12 trifft auf eine Innenwand 26 des Hohlwellenleiters 13 erstmals in einem Auftreffpunkt P1. Ein Winkel zwischen dem im Auftreffpunkt P1 auftretenden Beleuchtungslicht-Strahls 12 und der Innenwand 26 des Hohlwellenleiters 13 ist mit b bezeichnet. Ein Einfallswinkel 90°-b des Beleuchtungslichts 12 auf die Innenwand 26 ist im Punkt P1 und auch, was die späteren Auftreffpunkte Pi angeht, jeweils größer als 80°.

Die Innenwand 26 des Hohlwellenleiters 13 trägt Streustrukturen, die so an die Nutzwellenlänge des EUV-Beleuchtungslichts 12 angepasst sind, dass diese Streustrukturen eine beugende Wirkung haben, also Beugungsstrukturen darstellen. Diese Beugungsstrukturen streuen das auf die Innenwand 26 streifend einfallende EUV-Beleuchtungslicht 12 innerhalb eines Winkelbereichs um einen zum Einfallswinkel gleichen Ausfallswinkel. Dies ist in der Fig. 2 anhand dreier, vom Punkt P1 ausgehender, gestreuter beziehungsweise gebeugter Beleuchtungslichtstrahlen $12_1$, $12_2$ und $12_3$ dargestellt.

Der Beleuchtungslichtstrahl $12_1$ fällt vom Punkt P1 unter dem kleinsten Ausfallswinkel, also am wenigstens streifend aus, und erfährt anschließend noch weitere Reflexionen an den Punkten P2a, P3a, P4a und P5a an der Innenwand 26, bis dieser Beleuchtungslichtstrahl $12_1$ durch eine Austrittsöffnung 27 aus dem Hohlwellenleiter 13 austritt. Die Austrittsöffnung 27 liegt wiederum in einer Austrittsebene 28. Derjenige Abschnitt der Austrittsebene 28, der mit der Austrittsöffnung 27 zusammenfällt, wird auch als Austrittsfläche 29 bezeichnet.

Der Beleuchtungslichtstrahl $12_2$ liegt mittig im Streu- beziehungsweise Beugungs-Winkelbereich am Punkt P1, stellt also denjenigen Lichtstrahl dar, der mit einem Ausfallswinkel am Punkt P1 reflektiert wird, der so groß ist wie der Einfallswinkel am Punkt P1. Der Be-

leuchtungslichtstrahl $12_2$ erfährt anschließend noch weitere Reflexionen an den Punkten P2b und P3b an der Innenwand 26, bis dieser Beleuchtungslichtstrahl $12_2$ durch die Austrittsöffnung 27 aus dem Hohlwellenleiter 13 austritt und die Austrittsfläche 29 passiert.

Der dritte dargestellte Beleuchtungslichtstrahl $12_3$ erfährt am Punkt P1 die geringste streuende beziehungsweise beugende Ablenkung und wird im Anschluss lediglich einmal, nämlich am Punkt P4a an der Innenwand 26 des Hohlwellenleiters 13 reflektiert, bevor er die Austrittsfläche 29 durchtritt.

Ein Streuwinkel a (vgl. auch die Ausschnittsvergrößerung 2B der Figur 2) ist als halber Winkel zwischen den Beleuchtungslichtstrahlen $12_1$ und $12_3$ mit kleinstem und größtem Ausfallswinkel definiert.

Die Beugung, die die drei beispielhaft dargestellten Lichtstrahlen $12_1$, $12_2$, $12_3$ an den Punkten P2a, P2b, P3a, P4a, P3b, P2c und P5a erfahren, ist in der Fig. 2 nicht gezeigt. Dort ist schematisch nur jeweils der mit Ausfallswinkel gleich Einfallswinkel reflektierte Strahl gezeigt. Tatsächlich streuen beziehungsweise beugen die Beugungsstrukturen an der Innenwand 26 das einfallende Beleuchtungslicht 12 auch an diesen weiteren Auftreffpunkten Pi, was zu einer weiteren Vergrößerung des resultierenden Ausfallswinkelspektrums, insbesondere in der Austrittsfläche 29, führt.

Der Winkelbereich, innerhalb dem die Beleuchtungslichtstrahlen $12_1$, $12_2$, $12_3$ am Punkt P1 um den Ausfallswinkel des Beleuchtungslichtstrahls $12_2$ gestreut beziehungsweise gebeugt werden, liegt im Bereich zwischen 0 mrad und 20 mrad und kann besonders im Bereich zwischen 1 mrad und 5 mrad liegen.

Für die Ausführung der Beugungs- beziehungsweise Streustrukturen gilt, was in der WO 2014/139815 A1 in dort angegebenen Referenzen angegeben ist.

Eine Ausgestaltung des Hohlwellenleiters 13, insbesondere ein Verhältnis L/D aus einer Länge L des Hohlwellenleiters 13 einerseits und einem typischen Innendurchmesser D der Eintrittsöffnung 23 beziehungsweise der Austrittsöffnung 27 andererseits, ist derart, dass ein Einfallswinkel 90°-b des EUV-Beleuchtungslichts 12, welches den Hohlwellenleiter 13 zwischen der Eintrittsöffnung 23 und der Austrittsöffnung 27 nach maximal fünf Reflexionen durchtritt, auf der Innenwand 26 des Hohlwellenleiters 13 größer ist als 70°. Dieser Mindest-Einfallswinkel kann am Auftreffpunkt Pi auch noch größer sein, beispielsweise größer sein als 75°, größer sein als 78°, größer sein als 80°, größer sein als 82°, größer sein als 84° oder größer sein als 86°.

Ein Dimensionsverhältnis L/D ist größer als 20. Dieses Verhältnis L/D kann größer sein als 25, kann größer sein als 30, kann größer sein als 35, kann größer sein als 40, kann größer sein als 50 und kann auch noch größer sein.

Die Innenwand 26 des Hohlwellenleiters 13 trägt eine Reflexionsbeschichtung für das Beleuchtungslicht 12. Bei der Reflexionsbeschichtung kann es sich um eine Einlagen- oder auch um eine Mehrlagen-Beschichtung handeln. Bei der Reflexionsbeschichtung kann es sich um eine Ruthenium-Beschichtung handeln. Eine Mehrlagen-Beschichtung kann aus einer Mehrzahl von Bilagen gebildet sein, die beispielsweise als alternierende Schichten aus Molybdän oder Silizium ausgeführt sind.

Die Reflexionsbeschichtung der Innenwand 26 kann bei einem Einfallswinkel von 88° eine Reflektivität haben, die größer ist als 97 %.

Der Hohlwellenleiter 13 hat zwischen der Eintrittsöffnung 23 und der Austrittsöffnung 27 insgesamt einen rechteckigen und insbesondere quadratischen Innenquerschnitt.

Fig. 3 zeigt beispielhaft Ausfallswinkel des Beleuchtungslichts 12, welches einen mittleren Austrittspunkt P_e in der Austrittsfläche 29 durchtritt. Dargestellt sind beispielhaft sieben Einzelstrahlen $12_{e1}$ bis $12_{e7}$, wobei die äußeren Einzelstrahlen $12_{e1}$ und $12_{e7}$ diejenigen Strahlen mit den extremalen Ausfallswinkeln innerhalb des Ausfallswinkelspektrums am Austrittspunkt P_e repräsentieren.

Bedingt durch verschiedene Streu- beziehungsweise Beugungswinkel bei der Reflexion an der Innenwand 26 und auch bedingt durch die unterschiedliche Anzahl der Reflexionen des Beleuchtungslichts an der Innenwand 26 ergibt sich ein breites Ausfallswinkelspektrum ASW zwischen den Strahlen $12_{e1}$ und $12_{e7}$, die diesen Austrittspunkt P_e durchtreten. Dieses Ausfallswinkelspektrum ASW überdeckt einen Winkelbereich von etwa 40°. Das Ausfallswinkelspektrum ASW kann je nach Ausführung der optischen Baugruppe 13 auch einen Winkelbereich von 10° bis hin zu einem Winkelbereich von 20° überdecken. Für das halbe Ausfallswinkelspektrum, ASW/2 (vgl. Fig. 2B) gilt:

$$ASW/2 = \text{llw}/D$$

llw ist dabei der halbe eindimensionale Lichtleitwert, also der Durchmesser D des Hohlwellenleiters 13 mal der ausgangsseitigen numerischen Apertur NA.

Die verschiedenen Beleuchtungslichtstrahlen $12_{e1}$ bis $12_{ei}$, die den Austrittpunkt P_e durchtreten, haben in der Regel unterschiedliche Reflexions-Anzahlen an der Innenwand 26 des Hohlwellenleiters 13 erfahren. Es ergibt sich eine Intensitätsdurchmischung, was dazu führt, dass die Austrittsfläche 29 des Hohlwellenleiters 13 aufgrund der Streuung beziehungsweise der Beugung der Beugungsstrukturen der Innenwand 26 mit einer homogenisierten Intensitätsverteilung ausgeleuchtet wird. Zu dieser Intensitätsverteilung über die Austrittfläche 29 gehören eine maximale Intensität $I_{max}$ und eine minimale Intensität $I_{min}$. Für die homogenisierte Intensitätsverteilung gilt:

$$(I_{max} - I_{min})/(I_{max} + I_{min}) < 0,1$$

Die obere Grenze für die Homogenität der Intensitätsverteilung kann auch kleiner sein als 0,1 und kann beispielsweise 0,08; 0,06; 0,05; 0,04; 0,03 betragen oder auch einen noch kleineren Wert haben.

Aufgrund der unterschiedlichen Weglängen, die größer sein können als eine Kohärenzlänge k der Lichtquelle 2 ergibt sich auch eine gute Vermeidung beziehungsweise Mischung auftretender Speckle-Muster. Ein Speckle-Kontrast, gemessen über die Austrittfläche 29, ist entsprechend deutlich reduziert.

Aufgrund der erwähnten Durchmischung ergibt sich zudem der Effekt, dass eine Mehrzahl unterschiedlicher, immer noch auftretender Speckle-Muster sich statistisch zur gesamten Beleuchtungslicht-Intensitätsverteilung über die Austrittsfläche 29 addieren, sich dabei herausmitteln und somit den Kontrast noch weiter reduzieren.

Aufgrund der hohen Reflektivität der Innenwand 26 bei den verwendeten großen, streifenden Einfallswinkeln ergibt sich ein gesamter Reflexionsverlust für das Beleuchtungslicht 12 zwischen der Eintrittsöffnung 23 und der Austrittsöffnung 27, der kleiner sein kann als 30 %, als 25 %, als 20 %, oder sogar kleiner sein kann als 15 %.

Die Auslegung von Dimensionen des Hohlwellenleiters 13 einschließlich dessen Streustrukturen sowie eine Einkopplung des EUV-Beleuchtungslichts 2 in den Hohlwellenleiter 13 kann mindestens einer der nachfolgend angegebenen Relationen genügen:

1. Größenrelation zwischen Innendurchmesser D des Hohlwellenleiters 13, der Länge L des Hohlwellenleiters 13 und dem Einfallswinkel 90°-b:

$$5\,D\,/\,L \le b \le 1/10$$

Diese Relation ermöglicht bei gegebener Geometrie des Hohlwellenleiters 13 eine ausreichende, aber nicht zu große Reflexions-Anzahl.

2. Relation zwischen dem Lichtleitwert llw, dem Streuwinkel a und dem Innendurchmesser D des Hohlwellenleiters 13:

$$llw\,/\,25 \le a\,D \le 5\,llw$$

Diese Relation stellt sicher, dass der Streuwinkel a in einer gleichen Größenordnung ist wie eine Divergenz der ausfallenden Einzelstrahlen beim Austritt aus dem Hohlwellenleiter 13.

3. Relation zwischen dem Einfallswinkel 90°-b und dem Streuwinkel a:

$$b\,/\,5 \le a \le b$$

Diese Relation stellt sicher, dass der am Punkt P1 einfallende EUV-Strahl 12 vollständig gestreut wird.

4. Relation zwischen der Länge L des Hohlwellenleiters 13, der Kohärenzlänge k, dem Streuwinkel a und dem Einfallswinkel 90°-b:

$$L \ge \frac{k}{\dfrac{1}{\cos(a+b)} - \dfrac{1}{\cos b}}$$

Diese Relation stellt sicher, dass ein Wegunterschied zweier Strahlen des EUV-Beleuchtungslichts 12 (gestreut und ungestreut) mindestens gleich der Kohärenzlänge k des EUV-Beleuchtungslichts 12 ist, so dass dann eine entsprechende Specklereduktion stattfindet.

5. Relation zwischen der Länge L des Hohlwellenleiters 13, der Nutzwellenlänge λ des EUV-Beleuchtungslichts 12, dem Innendurchmesser D des Hohlwellenleiters 13 und der Strukturgröße s der Streu- beziehungsweise Beugungsstrukturen:

$$L \cdot \lambda\,/\,D \ge s \ge 10\,\lambda$$

Zur Herstellung eines mikro- oder nanostrukturierten Bauteils wird die Projektionsbelichtungsanlage 4 folgendermaßen eingesetzt: Zunächst werden das Retikel 10 und der Wafer 11 bereitgestellt. Dann wird eine Struktur auf dem Retikel 10 auf eine lichtempfindliche Schicht des Wafers 11 mithilfe der Projektionsbelichtungsanlage 4 projiziert. Durch Entwicklung der lichtempfindlichen Schicht wird dann eine Mikrostruktur auf dem Wafer 11 und somit das mikro- beziehungsweise nanostrukturierte Bauteil erzeugt.

**Patentansprüche**

1. Hohlwellenleiter (13) zur Führung von EUV-Licht (12) einer EUV-Lichtquelle (2) mit einer Nutzwellenlänge und einem Lichtleitwert, der kleiner ist als 0,1 mm$^2$,

   - mit einer Innenwand (26), die Beugungsstrukturen trägt, die an die Nutzwellenlänge angepasst sind und das auf die Innenwand (26) mit einem Einfallswinkel einfallende EUV-Licht (12) innerhalb eines Winkelbereichs um einen Ausfallswinkel beugen, wobei der Winkelbereich größer ist als 0 mrad.

2. Hohlwellenleiter nach Anspruch 1, **gekennzeichnet durch** eine Ausgestaltung so, dass ein Einfallswinkel des EUV-Lichts (12), welches den Hohlwellenleiter (13) nach maximal fünf Reflexionen durchtritt, auf der Innenwand (26) des Hohlwellenleiters (13)

größer ist als 70°.

3. Hohlwellenleiter nach Anspruch 1 oder 2, **dadurch gekennzeichnet, dass** der Hohlwellenleiter (13) ein Verhältnis aus Länge L und typischen Innendurchmesser D hat, das größer ist als 20.

4. Hohlwellenleiter nach einem der Ansprüche 1 bis 3, **dadurch gekennzeichnet, dass** die Innenwand (26) eine Reflexionsbeschichtung trägt.

5. Hohlwellenleiter nach einem der Ansprüche 1 bis 4, **kennzeichnet durch** einen rechteckigen Innenquerschnitt.

6. Hohlwellenleiter nach einem der Ansprüche 1 bis 5, **gekennzeichnet durch** ein Ausführung derart, dass eine Austrittsfläche (29) des Hohlwellenleiters (13) im Betrieb aufgrund der Beugung der Beugungsstrukturen mit einer Intensitätsverteilung ausgeleuchtet wird, zu der eine maximale Intensität ($I_{max}$) und eine minimale Intensität ($I_{min}$) gehören, wobei gilt:

$$(I_{max} - I_{min})/(I_{max} + I_{min}) < 0{,}1$$

7. Beleuchtungsoptik (1) zur Beleuchtung eines Objektfeldes (6), in dem ein abzubildendes Objekt (10) anordenbar ist, **gekennzeichnet durch** einen Hohlwellenleiter nach einem der Ansprüche 1 bis 6.

8. Optisches System mit einer Beleuchtungsoptik nach Anspruch 7 und mit einer Projektionsoptik (3) zur Abbildung des Objektfeldes (6) in ein Bildfeld (7), in dem ein Wafer (11) anordenbar ist.

9. Beleuchtungssystem (5) mit einer Beleuchtungsoptik nach Anspruch 7 und mit einer EUV-Lichtquelle (2).

10. Beleuchtungssystem nach Anspruch 9, **dadurch gekennzeichnet, dass** die EUV-Lichtquelle (2) eine Kohärenzlänge (k) hat, die größer ist als 1 μm.

11. Beleuchtungssystem nach Anspruch 9 oder 10, **dadurch gekennzeichnet, dass** mindestens eine der folgenden Relationen gilt:

$$5\,D\,/\,L \leq b \leq 1/10;$$

$$llw\,/\,25 \leq a\,D \leq 5\,llw;$$

$$b\,/\,5 \leq a \leq b;$$

$$L \geq \frac{k}{\dfrac{1}{\cos(a+b)} - \dfrac{1}{\cos b}};$$

$$L \cdot \lambda\,/\,D \geq s \geq 10\,\lambda;$$

wobei für die Parameter dieser Relationen gilt:

D: Innendurchmesser einer Eintrittsöffnung (23) des Hohlwellenleiters (13);
L: Länge des Hohlwellenleiters (13);
90°-b: Einfallswinkel von EUV-Beleuchtungslicht (12) in den Hohlwellenleiter (13);
llw: Eindimensionaler Lichtleitwert (D x numerischer Apertur NA des Hohlwellenleiters (13));
a: Beugungswinkel von Streustrukturen an einer Innenwand (26) des Hohlwellenleiters (13); und
k: Kohärenzlänge der EUV-Lichtquelle (2);
λ: Nutzwellenlänge des EUV-Beleuchtungslichts (12);
s: Typische Größe von Streu- beziehungsweise Beugungsstrukturen an der Innenwand (26) des Hohlwellenleiters (13).

12. Projektionsbelichtungsanlage (4) mit einem Beleuchtungssystem nach Anspruch 10 oder 11 und mit einer Projektionsoptik (3) zur Abbildung des Objektfeldes (6) in ein Bildfeld (7), in dem ein Wafer (11) anordenbar ist.

13. Verfahren zur mikrolithographischen Herstellung mikro- oder nanostrukturierter Bauteile mit folgenden Schritten:

- Bereitstellen eines Substrats, auf das zumindest teilweise eine Schicht aus einem lichtempfindlichen Material aufgebracht ist,
- Bereitstellen eines Retikels, das abzubildende Strukturen aufweist,
- Bereitstellen einer Projektionsbelichtungsanlage (4) nach Anspruch 12,
- Projizieren wenigstens eines Teils des Retikels auf einen Bereich der Schicht mit Hilfe der Projektionsbelichtungsanlage (4).

**Claims**

1. Hollow waveguide (13) for guiding EUV light (12) of an EUV light source (2) with a used wavelength and an etendue that is smaller than 0.1 mm$^2$,

- having an internal wall (26) carrying diffraction structures that are adapted to the used wavelength and diffract the EUV light (12) incident on the internal wall (26) at an angle of incidence within an angle range about an angle of reflection, wherein the angle range is greater than 0 mrad.

2. Hollow waveguide according to Claim 1, **characterized by** an embodiment such that an angle of incidence of the EUV light (12), which passes through the hollow waveguide (13) after at most five reflections, on the internal wall (26) of the hollow waveguide (13) is greater than 70°.

3. Hollow waveguide according to Claim 1 or 2, **characterized in that** the hollow waveguide (13) has a ratio of length L and typical internal diameter D that is greater than 20.

4. Hollow waveguide according to one of Claims 1 to 3, **characterized in that** the internal wall (26) has a reflective coating.

5. Hollow waveguide according to one of Claims 1 to 4, **characterized by** a rectangular internal cross section.

6. Hollow waveguide according to one of Claims 1 to 5, **characterized by** an embodiment such that an exit face (29) of the hollow waveguide (13) during operation is lit, due to the diffraction of the diffraction structures, with an intensity distribution that includes a maximum intensity ($I_{max}$) and a minimum intensity ($I_{min}$), wherein:

$$(I_{max} - I_{min}) / (I_{max} + I_{min}) < 0.1$$

7. Illumination optical unit (1) for illuminating an object field (6) in which an object (10) to be imaged is arrangeable, **characterized by** a hollow waveguide according to one of Claims 1 to 6.

8. Optical system having an illumination optical unit according to Claim 7 and having a projection optical unit (3) for imaging the object field (6) into an image field (7), in which a wafer (11) is arrangeable.

9. Illumination system (5) comprising an illumination optical unit according to Claim 7 and comprising an EUV light source (2).

10. Illumination system according to Claim 9, **characterized in that** the EUV light source (2) has a coherence length (k) that is greater than 1 $\mu$m.

11. Illumination system according to Claim 9 or 10, **characterized in that** at least one of the following relationships applies:

$$5 \, D \, / \, L \leq b \leq 1/10;$$

$$llw \, / \, 25 \leq a \, D \leq 5 \, llw;$$

$$b \, / \, 5 \leq a \leq b;$$

$$L \geq \frac{k}{\frac{1}{\cos(a+b)} - \frac{1}{\cos b}};$$

$$L \cdot \lambda \, / \, D \geq s \geq 10 \, \lambda;$$

wherein for the parameters of said relationships:

D: internal diameter of an entrance opening (23) of the hollow waveguide (13);
L: length of the hollow waveguide (13);
90°-b: angle of incidence of EUV illumination light (12) into the hollow waveguide (13);
llw: one-dimensional etendue (D x numerical aperture NA of the waveguide (13));
a: diffraction angle of scattering structures at an internal wall (26) of the hollow waveguide (13); and
k: coherence length of the EUV light source (2);
$\lambda$: used wavelength of the EUV illumination light (12);
s: typical size of scattering or diffraction structures at the internal wall (26) of the hollow waveguide (13).

12. Projection exposure apparatus (4) comprising an illumination system according to Claim 10 or 11 and comprising a projection optical unit (3) for imaging the object field (6) into an image field (7), in which a wafer (11) is arrangeable.

13. Method for microlithographically producing microstructured or nanostructured components, including the following steps:

- providing a substrate, to which a layer composed of a light-sensitive material is at least partly applied,
- providing a reticle which has structures to be imaged,
- providing a projection exposure apparatus (4) according to Claim 12,
- projecting at least part of the reticle onto a region of the layer with the aid of the projection exposure apparatus (4).

**Revendications**

1. Guide d'onde creux (13) destiné à guider une lumière EUV (12) d'une source de lumière EUV (2) ayant une longueur d'onde utile et une conductance lumineuse qui est inférieure à 0,1 mm², ledit guide d'onde creux comprenant

   - une paroi intérieure (26) qui porte des structures de diffraction qui sont adaptées à la longueur d'onde utile et qui diffractent la lumière EUV (12), incidente à la paroi intérieure (26) avec un angle d'incidence, d'un angle de réflexion dans une plage angulaire, la plage angulaire étant supérieure à 0 mrad.

2. Guide d'onde creux selon la revendication 1, **caractérisé par** une configuration selon laquelle un angle d'incidence de la lumière EUV (12), qui traverse le guide d'onde creux (13) après un maximum de cinq réflexions, à la paroi intérieure (26) du guide d'ondes creux (13) est supérieur à 70°.

3. Guide d'onde creux selon la revendication 1 ou 2, **caractérisé en ce que** le guide d'onde creux (13) a un rapport longueur L à diamètre intérieur typique D supérieur à 20.

4. Guide d'onde creux selon l'une des revendications 1 à 3, **caractérisé en ce que** la paroi intérieur (26) porte un revêtement réfléchissant.

5. Guide d'onde creux selon l'une des revendications 1 à 4, **caractérisé par** une section transversale intérieure rectangulaire.

6. Guide d'onde creux selon l'une des revendications 1 à 5, **caractérisé par** un mode de réalisation selon lequel une surface de sortie (29) du guide d'onde creux (13) est éclairée en fonctionnement en raison de la diffraction des structures de diffraction avec une distribution d'intensité à laquelle appartiennent une intensité maximale ($I_{max}$) et une intensité minimale ($I_{min}$), avec :

   $$(I_{max} - I_{min}) / (I_{max} + I_{min}) < 0,1$$

7. Optique d'éclairage (1) destinée éclairer un champ objet (6) dans lequel peut être disposé un objet (10) à reproduire, **caractérisée par** un guide d'onde creux selon l'une des revendications 1 à 6.

8. Système optique comprenant une optique d'éclairage selon la revendication 7 et une optique de projection (3) afin de reproduire le champ objet (6) dans un champ image (7) dans lequel peut être disposée une plaquette de silicium (11).

9. Système d'éclairage (5) comprenant une optique d'éclairage selon la revendication 7 et une source de lumière EUV (2).

10. Système d'éclairage selon la revendication 9, **caractérisé en ce que** la source de lumière EUV (2) a une longueur de cohérence (k) qui est supérieure à 1 μm.

11. Système d'éclairage selon la revendication 9 ou 10, **caractérisé en ce qu'**au moins l'une des relations suivantes s'applique :

    $$5 \; D \; / \; L \; \leq \; b \; \leq \; 1/10 \; ;$$

    $$llw \; / \; 25 \; \leq \; a \; D \; \leq \; 5 \; llw \; ;$$

    $$b \; / \; 5 \; \leq \; a \; \leq \; b \; ;$$

    $$L \geq \frac{k}{\dfrac{1}{\cos(a+b)} - \dfrac{1}{\cos b}}$$

    les paramètres de ces relations étant :

    D : diamètre intérieur d'une ouverture d'entrée (23) du guide d'onde creux (13) ;
    L : longueur du guide d'onde creux (13) ;
    90°-b : angle d'incidence de la lumière d'éclairage EUV (12) dans le guide d'onde creux (13) ;
    llw : conductance lumineuse unidimensionnelle (D x ouverture numérique NA du guide d'onde creux (13)) ;
    a : angle de diffraction de structures de diffusion sur une paroi intérieure (26) du guide d'onde creux (13) ; et
    k : longueur de cohérence de la source de lumière EUV (2) ;
    λ : longueur d'onde utile de la lumière d'éclairage EUV (12) ;
    s : dimension typique de structures de diffusion ou de diffraction sur la paroi intérieure (26) du guide d'ondes creux (13).

12. Installation d'illumination par projection (4) comprenant un système d'éclairage selon la revendication 10 ou 11 et une optique de projection (3) afin de reproduire le champ objet (6) dans un champ image (7) dans lequel peut être disposée une plaquette de silicium (11).

13. Procédé de production micro-lithographique de composants micro-structurés ou nano-structurés, ledit procédé comprenant les étapes suivantes :

- fournir un substrat sur lequel une couche d'un matériau photosensible est au moins partiellement appliquée,
- fournir un réticule qui comporte des structures à reproduire,
- fournir un système d'illumination par projection (4) selon la revendication 12,
- projeter au moins une partie du réticule sur une zone de la couche à l'aide de l'installation d'illumination par projection (4).

Fig. 1

EP 3 559 751 B1

Fig. 2A

Fig. 2B

Fig. 3

EP 3 559 751 B1

**IN DER BESCHREIBUNG AUFGEFÜHRTE DOKUMENTE**

**In der Beschreibung aufgeführte Patentdokumente**

- DE 102016225563
- WO 2014139881 A1
- WO 2013174644 A1
- WO 2014139815 A1
- DE 102013204443 A1
- US 6552846 B1
- WO 2016046088 A1
- US 20110058388 A1
- US 5109465 A
- EP 1058156 A2
- US 20060132747 A1
- EP 1614008 B1
- US 6573978 B

**In der Beschreibung aufgeführte Nicht-Patentliteratur**

- **VON JOSEPH W. GOODMAN.** Speckle Phenomena in Optics: Theory and Applications. Roberts & Company, 2007